# EUROPEAN PATENT APPLICATION

(11) **EP 3 373 018 A1**
(43) Date of publication of application: **12.09.2018**
(21) Application number: 17159301.5
(22) Date of filing: 06.03.2017
(51) Int. Cl.: G01R 19/00, G01R 19/02, G01R 19/165, H02M 3/156, H05B 33/08

(54) **METHOD AND CIRCUIT FOR MEASURING CURRENT IN A LED DRIVER**

(71) Applicant: Helvar Oy Ab, 02150 Espoo (FI)
(72) Inventor: SYVÄRANTA, Lauri, 02150 ESPOO (FI)
(74) Representative: Berggren Oy, Helsinki & Oulu

(57) **Abstract**

A driver device for one or more semiconductor light sources comprises a current path for conducting a periodically increasing and decreasing current controlled by said driver device. Said current is the same as or indicative of the output current of the driver device through said semiconductor light sources. An AC measurement circuit is coupled to said current path or to a further current path configured to conduct an alternating current indicative of an AC component of said periodically increasing and decreasing current. A DC measurement circuit is coupled to said current path through the first input of an error amplifier, a second input of which is coupled to a reference. The output of the error amplifier is coupled to said DC measurement value output. A combining circuit combines the AC measurement value output and the DC measurement value output into a superposition value indicative of the magnitude of said periodically increasing and decreasing current.

## Description

### FIELD OF THE INVENTION

The invention relates to measuring an electric current that has both a DC component and an AC component. In particular the invention relates to measuring a periodically increasing and decreasing current, the mean value of which is indicative of the effective current through the semiconductor light sources driven by a driver device comprising a switched-mode power supply.

### BACKGROUND OF THE INVENTION

Switched-mode power supplies are commonly used to drive semiconductor light sources such as LEDs (light-emitting diodes). An example is a hysteresis controlled buck converter, in which a power switch is kept on until the current through the current measurement point reaches an upper limiting value, at which point the power switch is switched off. The current through the measurement point decreases until it reaches a lower limiting value, at which point the power switch is switched on again. The mean value of the current lies between the upper and lower limiting values. The current measurement point may be directly on the current path through the LEDs, so that the measured current is the same as the LED current, but also other possibilities exist: the current measurement point may be selected so that the measured current will provide an indirect indication of the LED current.

The switching frequency of the power switch may be in the order of hundreds of kilohertz. In order to perform the switch-on and switch-off operations correctly the current measurement circuit should act relatively fast. At the same time in order to maintain the effective LED current at an appropriate value the current measurement circuit should be relatively accurate. In order to keep the manufacturing costs under control the components of the current measurement circuit must not be very expensive, and in order to avoid unnecessarily wasting energy and to keep operating temperatures down the circuit should not consume much power. These are all somewhat contradictory requirements, because for example fast and accurate operational amplifiers tend to be expensive and/or draw a lot of current. It does not take much exaggeration to say that operational amplifiers are either fast, accurate, cheap, or energy efficient, or in exceptional cases at most two of these simultaneously.

### SUMMARY OF THE INVENTION

It is an objective of the present invention to provide a method and a circuit for measuring a periodically increasing and decreasing electric current fast and accurately with advantageously priced components and modest current consumption. A further objective of the invention is that the method and circuit are scalable and applicable to different magnitudes of measured currents and different frequencies of the periodic increasing and decreasing. An objective of the invention is that the speed and accuracy of the method and circuit are sufficient for using the measured current as an indication of the current through LEDs so that even small currents, corresponding to deeply dimmed state of the LEDs, can be measured reliably. A yet another objective of the invention is that the method and circuit are applicable in mass production where component tolerances must be taken into account.

The objectives of the invention are achieved by using an error amplifier circuit to measure a DC component and an AC measurement circuit to measure an AC component of the current to be measured, and by superposing these two measurements to produce an indication of the total measured current.

According to an aspect of the invention there is provided a driver device for one or more semiconductor light sources. The characteristic features of the driver device are listed in the independent claim directed to a driver device.

According to another aspect of the invention there are provided a method, the characteristic features of which are listed in the independent claims directed to a method.

The exemplifying embodiments of the invention presented in this patent application are not to be interpreted to pose limitations to the applicability of the appended claims. The verb "to comprise" and its derivatives are used in this patent application as an open limitation that does not exclude the existence of features that are not recited. The features described hereinafter are mutually freely combinable unless explicitly stated otherwise.

The novel features which are considered as characteristic of the invention are set forth in particular in the appended claims. The invention itself, however, both as to its construction and its method of operation, together with additional objects and advantages thereof, will be best understood from the following detailed description of specific embodiments when read in connection with the accompanying drawings.

### BRIEF DESCRIPTION OF THE DRAWINGS

Figure 1 illustrates a principle of superposing AC and DC component measurements,
figure 2 illustrates an example of measuring a current in a LED driver,
figure 3 illustrates another example of measuring a current in a LED driver,
figure 4 illustrates another example of measuring a current in a LED driver,
figure 5 illustrates an example of a measurement circuit,
figure 6 illustrates another example of a measurement circuit,
figure 7 illustrates another example of a measurement circuit, and
figure 8 illustrates another example of a measurement circuit.

### DETAILED DESCRIPTION

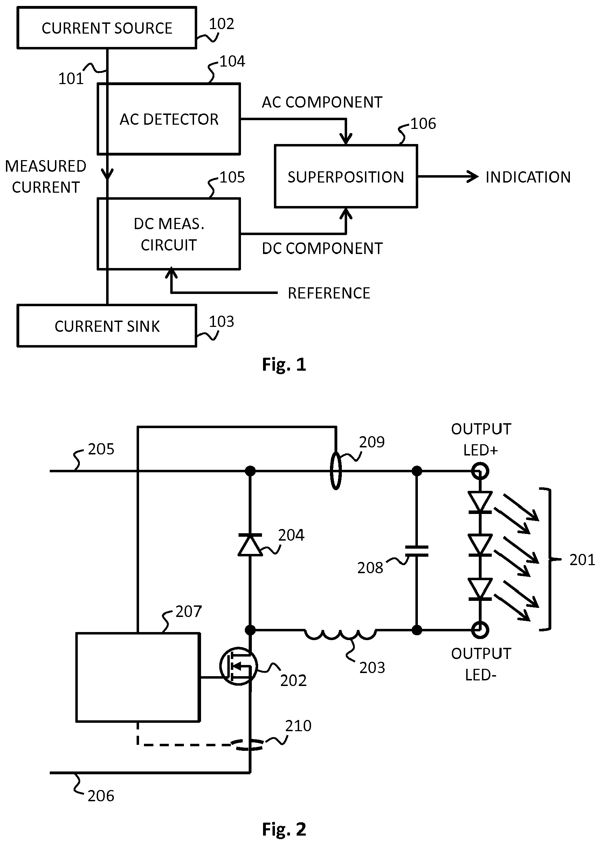

Fig. 1 illustrates a principle according to which a current path 101 runs between a current source 102 and a current sink 103. In the context of the present invention the current source 102, current path 101, and current sink 103 are parts of a driver device for one or more semiconductor light sources. The current to be measured flows through the current path 101. It is a periodically increasing and decreasing current that is controlled by the driver device. The magnitude of the current to be measured is the same as or indicative of an output current that the driver device drives through the one or more semiconductor light sources. The current source 102 and current sink 103 do not need to be directly at the ends of a single electric conductor; the topology may be much more complicated. The current source 102 and current sink 103 are shown in fig. 1 merely as a reminder that the current to be measured must come from somewhere and go somewhere.

According to the principle shown in fig. 1 there is an AC measurement circuit, which can also be called an AC detector 104 for short. The AC measurement circuit comprises a measured AC input, through which the alternating current to be measured enters the circuit, and an AC measurement value output. The measured AC input is coupled to the current path 101 in fig. 1. For example if a current transformer with a primary winding and a secondary winding is used as (a part of) the AC measurement circuit, the current to be measured flows through the primary winding. The task of the secondary winding of the current transformer is to generate a (scaled) image current as dictated by the inductive coupling of the two windings. From the secondary winding one may obtain a measurement value, the magnitude of which is proportional to the magnitude of the AC component included in the current to be measured. The primary winding of the current transformer is a part of the current path 101. Other possible forms of an AC measurement circuit are described later in this text.

Also according to the principle shown in fig. 1 there is a DC measurement circuit 105, a measured DC input of which is coupled to the current path 101. From a DC measurement value output of the DC measurement circuit 105 one may obtain a DC measurement value, the magnitude of which is proportional to the magnitude of the DC component included in the current to be measured.

The DC measurement circuit 105 is capable of internally producing a reference value, or comprises an input for receiving a reference value produced elsewhere in the driver device. Although not separately shown in fig. 1, the DC measurement circuit 105 comprises an error amplifier with two inputs and an output. A first input of the error amplifier is coupled to the measured DC input, and a second input of the error amplifier is coupled to the reference. The output of the error amplifier is coupled to the DC measurement value output, so it has a significant effect on the value that the DC measurement circuit 105 provides as a signal that represents the DC component of the current to be measured.

Further according to the principle shown in fig. 1 there is a combining circuit 106 that is configured to combine the signals obtained from the AC measurement value output of the AC measurement circuit 104 and from the DC measurement value output of the DC measurement circuit 105. The result of the combining is a superposition value indicative of the magnitude, in both AC and DC sense, of the periodically increasing and decreasing current that was to be measured.

An essential advantage of measuring the AC and DC components of the periodically increasing and decreasing current separately like in fig. 1 is that both the AC measurement circuit 104 and the DC measurement circuit 105 can be optimised for their respective tasks. In particular, any operational amplifier that is included in the error amplifier arrangement of the DC measurement circuit 105 does not need to be fast, because the lower measurement branch only needs to react relatively slowly, so that the signal at the DC measurement value output reflects the mean value of the periodically increasing and decreasing current that flows through the current path 101. Slow and accurate operational amplifiers come typically at a significantly lower component cost than fast and accurate ones.

Separating the measurements of the DC and AC components may also assist in adapting the measurement to different AC amplitudes and/or different DC levels. A current transformer can be again considered as an example. The secondary winding of a current transformer is floating in the potential sense by nature, so the same (or at least very similar) current transformer can be used regardless of the magnitude of the DC component, at least as long as the amplitude of the AC that is expected to be measured stays the same. Correspondingly the same DC measurement circuit may be applicable to cases with wide variety in the amplitude of the AC component, because it has an inherent low pass transfer function that is effective enough against to block the effect of AC of any amplitude.

Another advantage of the arrangement is the negligible effect of component value tolerances on the accuracy of selecting a lighting level. Particularly the components that take part in measuring the AC component have essentially no effect on the resulting overall lighting level, because the measurement of the AC component only deals with ripple in the current and not the effective (DC) value of the current, which defines the overall lighting level.

There are several possibilities for selecting the location at which the principle shown in fig. 1 is put into practice in the driver device for semiconductor light sources. Fig. 2 illustrates a couple of alternatives. According to fig. 2 the driver device for semiconductor light sources comprises a buck converter for generating the current through the semiconductor light sources, or LEDs 201 for short. Typical to a buck converter it comprises a power switch 202 and a current loop that comprises a closed path comprising, among others, the LEDs 201. Driver devices are often manufactured and sold separately from the LEDs, for which reason it can be said that the closed path is configured to comprise the semiconductor light sources; in the driver device *per se* the path is then not strictly speaking closed, because there is a connector for connecting a LED chain that actually closes the current path, but the term "closed path" is used in this text to cover also such cases. A current is configured to flow through said closed path during periods when the power switch 202 is not conductive. In the simplified embodiment of fig. 2 the current loop consists of the LEDs 201, the inductor 203, and the freewheeling diode 204. The current source in fig. 2 is the so-called upper rail or bus voltage line 205, and the current sink is the lower rail or local ground potential line 206.

A control circuit 207 forms the switching pulses that control the state of conductivity of the power switch 202. When the power switch 202 is conductive, an essentially linearly increasing current flows from the bus voltage line 205 through the LEDs 201, the inductor 203, and the power switch 202 to the local ground potential line 206. As the increasing current flows through the inductor 203 it stores energy into its magnetic field. When the switching pulse at its gate ends, the power switch 202 becomes non-conductive. The stored energy is discharged from the magnetic field of the inductor 203 in the form of a linearly decreasing current that flows through the current loop described above. A capacitor 208 across the output of the driver device acts to smoothen the flow of electric current through the LEDs 201.

At a measurement point 209 a periodically increasing and decreasing current is observed, so that the frequency of increasing and decreasing is the same as the switching frequency of the power switch 202. The topology of fig. 2 represents the so-called lower side switch buck converter, in which the power switch 202 is coupled between the current loop 201-203-204 and the lower rail (the local ground potential line 206). Comparing the illustrated location 209 to the principle of fig. 1, the section of interest of the current path shown as 101 in fig. is the section of said current loop that is located between the upper rail (the bus voltage line 205) and that output of the driver device that is meant for coupling an anode of at least one of the semiconductor light sources.

If a measurement circuit according to the principle shown in fig. 1 is placed at the measurement point 209 of fig. 2, it may provide the control circuit 207 with an indication of a current that is the sum of the current flowing through the LEDs 201 and the current flowing to the capacitor 208. Thus at the measurement point 209 a relatively good indication of the output current through the LEDs 201 can be obtained: although the measured current is not exactly the same as the output current, it is indicative of the magnitude of the output current. The control circuit 207 can use said indication when it forms the switching pulses for the power switch 202. The control circuit 207 may compare the superposition value generated according to the principle of fig. 1 to one or more limiting values or thresholds, and use the results of such comparing to time the switching of the power switch 202.

If the buck converter of fig. 2 is of the current hysteresis control type, a result that shows the superposition value reaching or exceeding an upper limiting value triggers switching the power switch 202 off. Correspondingly a result that shows the superposition value reaching or falling below a lower limiting value triggers switching the power switch 202 on. In general, the superposition value can be used to time the switching of the power switch of any switched-mode power supply that takes part in generating the output current through the LEDs 201; alternatives to the topology of fig. 2, with other kinds of switched-mode power supplies in the driver device, are discussed in more detail later.

Fig. 2 shows also an alternative location 210 for placing the current measurement point. Here the section of interest of the current path on which the measured current flows is located between the power switch 202 and the lower rail (the local ground potential line 206), outside the current loop 201-203-204. At location 210 a current naturally flows only during those time intervals when the power switch 202 is conductive. Yet, this current is a periodically increasing and decreasing current, even if it decreases to zero very rapidly when the conduction period of the power switch 202 ends. It is also indicative of the magnitude of the output current of the driver device. A current measurement made at location 210 can be used to time the moments when the power switch 202 should be switched off, by comparing the superposition value to an upper limiting value so that when the superposition value reaches or exceeds said upper limiting value, the power switch 202 is switched off.

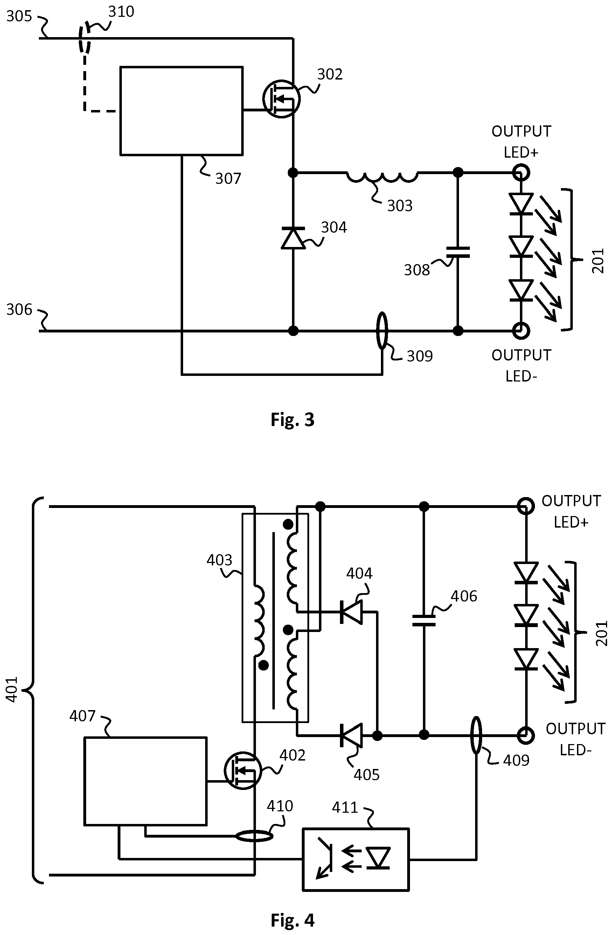

Fig. 3 shows a driver device for semiconductor light sources according to another embodiment of the invention. Similar to fig. 2, the driver device of fig. 3 comprises a buck converter for generating the current through the LEDs 201. The buck converter comprises a power switch 302 and a current loop that comprises a closed path (LEDs 201, diode 304, inductor 303) through which a current is configured to flow during which the power switch 302 is not conductive. A control circuit 307 forms the switching pulses for the power switch 302. A capacitor 308 smoothens the flow of current through the LEDs 201. As a difference to fig. 2 the buck converter of fig. 3 is of the so-called upper side switch type, which means that the power switch 302 is coupled between the upper rail (the bus voltage line 305) and the current loop 201-304-303.

According to fig. 3 a measurement circuit according to the principle shown in fig. 1 can be placed at the measurement point 309. It may provide the control circuit 307 with an indication of a current that is the sum of the current flowing through the LEDs 201 and the current flowing from the capacitor 308. This is a periodically increasing and decreasing current accurately indicative of an output current through the LEDs 201. Thus in this case the section of interest of the current path, through which the current to be measured flows, is a section of the current loop 201-304-303 between 1) an output of the driver device for coupling a cathode of at least one semiconductor light sources and 2) the lower rail (the local ground potential line 306). The measurement point 309 could also appear directly next to one node of the driver device output, i.e. to the right from the capacitor 308 in fig. 3. Placing the current measurement point so would involve the advantage of avoiding measuring some AC that only goes through the capacitor 308, which has less meaning if the LED current is the point of interest in the measurement.

In a manner that is comparable to the alternative location 210 of the current measurement in fig. 2, fig. 3 shows an alternative location 310 at which a current measurement could be performed using the principle shown in fig. 1. In the case of the alternative location 310 the section of interest of the current path is located between the upper rail (the bus voltage line 305) and the power switch 302, outside the current loop 201-304-303. At the alternative location 310 the periodically increasing and decreasing current has again the nature of increasing essentially linearly during the conduction interval of the power switch 302 and decreasing rapidly to zero when the power switch 302 becomes non-conductive, and the current measurement can be used in the control circuit 307 to time the moments of switching off the power switch 302 when the superposition value produced in the current measurement reaches or exceeds an upper limiting value.

Fig. 4 illustrates schematically a driver device for semiconductor light sources, which driver device comprises a primary side and a secondary side that is galvanically isolated from the primary side. The circuit topology of the driver device is that of a flyback converter with two parallel secondary windings. It comprises a DC power input 401, across which is a series connection of a power switch 402 and the primary winding of an isolation transformer 403. The two secondary windings of the isolation transformer 403 have an opposite polarity compared to the primary winding, and each of them has a diode 404, 405 connected in series with the secondary winding. The polarity of the windings and the use of the diodes 404, 405 mean that a current only flows in the secondary windings when no current flows in the primary winding and vice versa, according to the well-known operating principle of a flyback converter. A capacitor 406 smoothens the output current that flows through the LEDs 201.

Fig. 4 shows a couple of alternative approaches to selecting the measurement point at which a periodically increasing and decreasing current should be measured. The first measurement point 409 is an example of a case in which the section of interest of the current path, through which the current to be measured flows, is on the secondary side and is coupled to conduct at least an essential part of the current flowing through the semiconductor light sources. Taken that the power switch 402 and its control circuit 407 are on the primary side, and the current measurement made at the first measurement point 409 should have an effect on how the on and off switching of the power switch 402 is timed, feedback across the galvanic isolation border is needed. The driver device comprises a galvanically isolating feedback component (here: optoisolator 411) for conveying the superposition value produced according to the principle of fig. 1 from the secondary side to the primary side. The second measurement point 410 is an example of a case in which the section of interest of the current path is on the on the primary side and runs through a primary side inductor (i.e. the primary winding of the isolation transformer 403) and the power switch 402, of which the latter is configured to control a primary current through said primary side inductor.

In a driver device that involves galvanic separation between a primary side and a secondary side the measurements of the AC and DC components of the periodically increasing and decreasing current can be separated even so that one of them is performed on the primary side and the other on the secondary side. In such a case a galvanically isolating feedback component naturally only needs to carry one of the measured values across the galvanic isolation.

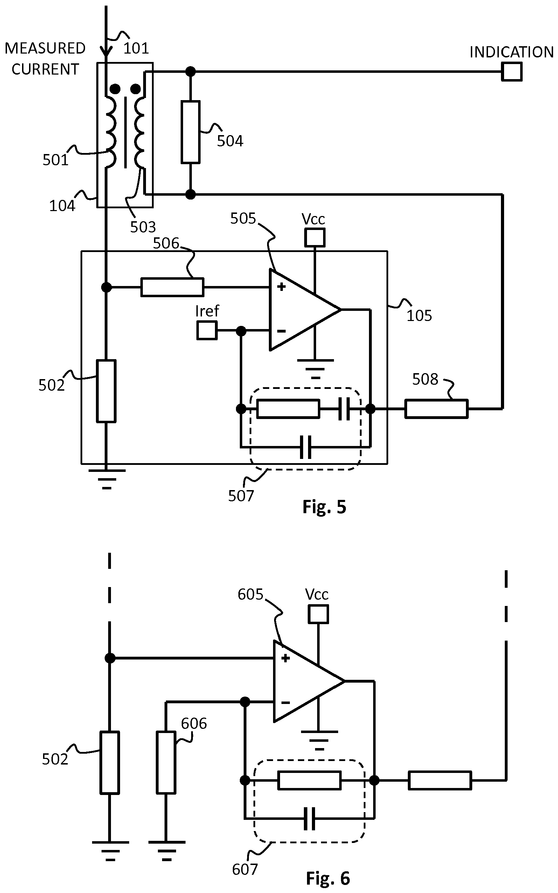

Fig. 5 illustrates schematically an example of how the principle of fig. 1 can be implemented in practice. The current source is not shown in fig. 5 but is expected to be somewhere at the upper end of the current path 101. The potential marked with the ground potential symbol acts as the current sink. The primary winding 501 of the current transformer 104 constitutes a part of the current path, as does a current sensing resistor 502 that is a part of the DC measurement circuit 105. Concerning the polarity of the windings of the current transformer 104, the primary winding 501 has a first terminal and a second terminal, so that the direction of the periodically increasing and decreasing current is into the first terminal and out of the second terminal (from up to down in fig. 5). The secondary winding 503 of the current transformer 104 has also a first terminal and second terminal, which correspond to the respective terminals of the primary winding as is shown with the parallel black dots in the drawing. The combining circuit, the task of which is to produce the superposition value, comprises a resistive connection 504 between the first and second terminals of the secondary winding 503 of the current transformer 104.

The exemplary DC measurement circuit 105 in fig. 5 comprises an error amplifier 505, the non-inverting input of which constitutes (or more generally: is coupled to; note resistor 506 in fig. 5) the measured DC input of the DC measurement circuit 105. The inverting input of the operational amplifier 505 is coupled to receive a reference potential that represents a desired mean value of the current flowing through the current path 101. The output of the error amplifier 505 constitutes the DC measurement value output of the DC measurement circuit 105. The predominantly capacitive feedback coupling 507 between the output and the inverting input of the error amplifier 505 makes it operate as an integrator, so that the measurement value produced by the DC measurement circuit is an integral of the difference between the measured, periodically increasing and decreasing current on the current path 101 and the desired mean value represented by the reference potential.

The DC measurement value output of the DC measurement circuit 105 is coupled to the second terminal of the secondary winding 503 of the current transformer 104 through a further resistor 508, which in the embodiment of fig. 5 constitutes the combining circuit together with the resistive connection 504 between the terminals of the secondary winding 503 in the current transformer 104.

Fig. 6 illustrates schematically another example of how the DC measurement circuit can be implemented in order to realize the principle of fig. 1 in practice. The AC measurement part, i.e. the current transformer and the resistive connection across its secondary winding, may be similar to that in fig. 5, so it is omitted in fig. 6. The DC measurement circuit of fig. 6 comprises an operational amplifier 605, the non-inverting input of which is coupled to the measured DC input of the DC measurement circuit. Just like in the embodiment of fig. 5 above, the measured DC input of the DC measurement circuit is coupled at one terminal of a current sensing resistor 502, the other terminal of which is coupled to the current sink. The inverting input of the operational amplifier 605 is coupled to a reference potential, which here is the local ground potential, through a resistor 606.

The resistive and capacitive feedback coupling 607 between the output and the inverting input of the operational amplifier 605 makes it operate as an active low-pass filter, so that the DC measurement value produced by the DC measurement circuit of fig. 6 is proportional to the DC voltage component across the current sensing resistor 502.

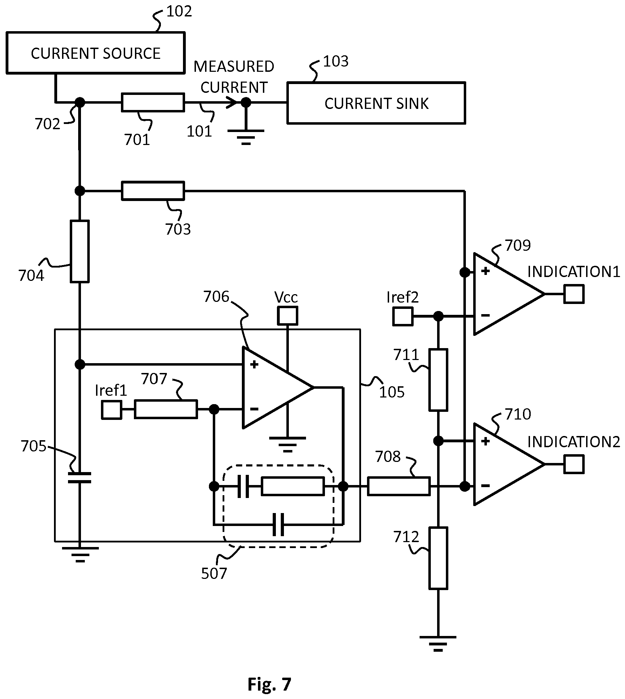

Fig. 7 illustrates schematically another example of how the DC and AC measurement circuits can be implemented in order to realize the principle of fig. 1 in practice. The current path 101 for conducting the periodically increasing and decreasing current goes between a current source 102 and a current sink 103 and comprises a current sensing resistor 701. A coupling 702 to one end of the current sensing resistor 701 constitutes both the measured AC input and the measured DC input. The AC measurement circuit comprises a simple resistive connection 703, so that the AC measurement value output appears as the other end of the resistive connection 703. The DC measurement circuit comprises an RC filter consisting of the resistor 704 and the capacitor 705 coupled between the measured DC input and the local ground potential. The filtered voltage from the RC filter is taken to the non-inverting input of the error amplifier 706, so in other words the first input of the error amplifier 706 is coupled to the measured DC input at point 702 through an RC filter. Other low-pass type filters could be used in place of the RC filter shown in fig. 7.

The inverting input of the error amplifier 706 is coupled to a reference potential marked as Iref1 in fig. 7 through a resistor 707. The predominantly capacitive feedback coupling 507 between the output and the inverting input of the error amplifier 706 is similar to that in fig. 5 and makes the error amplifier 706 operate as an integrator, so that the measurement value produced by the DC measurement circuit of fig. 7 is an integral of the difference between the low-pass filtered and measured, periodically increasing and decreasing current on the current path 101 and the desired mean value represented by the reference potential Iref1.

In the embodiment of fig. 7 the combining circuit comprises a resistor 708, through which the output of the error amplifier 706 is coupled together with the AC measurement value output. This coupling point is coupled to the non-inverting input of a first differential amplifier 709 and to the inverting input of a second differential amplifier 710. A second reference potential Iref2 is coupled to the inverting input of the first differential amplifier 709. A scaled sample of said second reference potential Iref2 is coupled to the non-inverting input of the second differential amplifier 710. The scaling takes place in the voltage divider consisting of resistors 711 and 712 coupled in series between the second reference potential Iref2 and the local ground potential. The output of the first differential amplifier 709 is marked as INDICATION1 in fig. 7 and it goes high whenever the potential at the combination point of the DC and AC measurement value outputs is higher than the second reference potential Iref2. The output of the second differential amplifier 710 is marked as INDICATION2 in fig. 7 and it goes high whenever the potential at the combination point of the DC and AC measurement value outputs is lower than the scaled sample of the second reference potential Iref2.

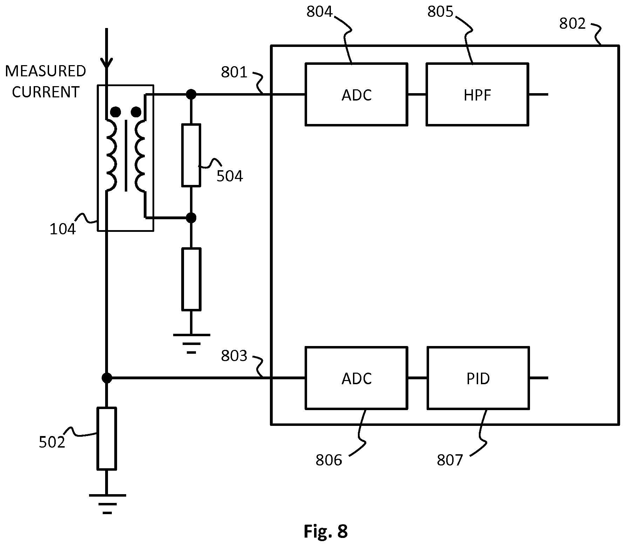

Fig. 8 illustrates schematically yet another example of how the principle of fig. 1 can be realized in practice. The connections of the primary winding of the current transformer to the current path are the same as in fig. 5, as is the resistive connection 504 between the terminals of the secondary winding of the current transformer 104, but the first terminal of the secondary winding is also coupled to a first analog input 801 of a programmable integrated circuit 802 such as a microcontroller or microprocessor. The DC measurement circuit comprises simply the current sensing resistor 502, so that the upper terminal of said current sensing resistor 502 acts as both the measured DC input and the measurement value output of the DC measurement circuit. It is coupled to a second analog input 803 of the programmable integrated circuit 802. The concept of a combining circuit now consists of internal components of the programmable integrated circuit 802; as an example the signal produced by the current transformer 104 is subjected to A/D conversion at block 804 and high pass filtering at block 805, while the voltage across the current sensing resistor 502 is taken to A/D conversion at block 806 and to a PID controller at block 807. The programmable integrated circuit 802 may use digital processing to implement these and other kinds of functional blocks.

Changes and modifications can be made to the exemplary embodiments described above without departing from the scope of protection defined by the appended claims. For example, the circuit diagrams of fig. 5 to 8 are simplified and exemplary compared to real life circuits that would follow the same basic topology and operating principle. In analogue electronics it is very common that a certain desired function can be implemented in practice in a very large variety of alternative ways. A current transformer may be a discrete component or it may be implemented with specifically formed conductive tracks on a circuit board. Other kinds of current-detecting components and methods can be used in place of a current transformer, and the AC measurement circuit does not even need to be located on the main current path: the driver device may comprise a further current path configured to conduct an alternating current that is indicative of the AC component of the periodically increasing and decreasing current of interest. Also while only one programmable integrated circuit 802 is shown in the schematic illustration of fig. 8, the functionalities explained to exist within the programmable integrated circuit may be divided between two or more circuits, only some of which need to be programmable and/or integrated.

## Claims

1. A driver device for one or more semiconductor light sources, comprising:
- a current path for conducting a periodically increasing and decreasing current, the magnitude of which is the same as or indicative of the magnitude of an output current of the driver device through said semiconductor light sources,
- an AC measurement circuit with a measured AC input and an AC measurement value output, of which said measured AC input is coupled to said current path or to a further current path configured to conduct an alternating current indicative of an AC component of said periodically increasing and decreasing current,
- a DC measurement circuit with a measured DC input and a DC measurement value output, of which said measured DC input is coupled to said current path,
- an error amplifier, a first input of which is coupled to said measured DC input, a second input of which is coupled to a reference, and the output of which is coupled to said DC measurement value output, and
- a combining circuit configured to combine signals from said AC measurement value output and said DC measurement value output into a superposition value indicative of the magnitude of said periodically increasing and decreasing current.

2. A driver device according to claim 1, wherein:
- the driver device comprises a buck converter for generating the output current through said semiconductor light sources,
- the buck converter comprises a power switch and a current loop that comprises a closed path configured to comprise said semiconductor light sources, through which closed path a current is configured to flow during periods when the power switch is not conductive, and
- said current path is a section of said current loop.

3. A driver device according to claim 2, wherein:
- said power switch is coupled between said current loop and a lower rail of said buck converter, and
- said current path is a section of said current loop located between an upper rail of said buck converter and an output of said driver device for coupling an anode of at least one of said semiconductor light sources.

4. A driver device according to claim 2, wherein:
- said power switch is coupled between an upper rail of said buck converter and said current loop, and
- said current path is a section of said current loop between an output of said driver device for coupling a cathode of at least one of said semiconductor light sources and a lower rail of said buck converter.

5. A driver device according to claim 1, wherein:
- the driver device comprises a buck converter for generating the output current through said semiconductor light sources,
- the buck converter comprises a power switch and a current loop that comprises a closed path configured to comprise said semiconductor light sources, through which closed path a current is configured to flow during periods when the power switch is not conductive, and
- said current path is located between said power switch and one of the upper and lower rails of said buck converter, outside said current loop.

6. A driver device according to claim 1, wherein:
- the driver device comprises a primary side and a secondary side galvanically isolated from said primary side, and
- said current path is on said primary side and runs through a primary side inductor and a power switch configured to control a primary current through said primary side inductor.

7. A driver device according to claim 1, wherein:
- the driver device comprises a primary side and a secondary side galvanically isolated from said primary side,
- said current path is on said secondary side and is coupled to conduct at least an essential part of the current flowing through said semiconductor light sources, and
- the driver device comprises a galvanically isolating feedback component for conveying said superposition value from said secondary side to said primary side.

8. A driver device according to any of the preceding claims, wherein:
- the AC measurement circuit comprises a current transformer with a primary winding and a secondary winding, of which the primary winding is a part of said current path,
- the primary winding of the current transformer has a first terminal and a second terminal, so that the direction of said periodically increasing and decreasing current is from said first terminal to the second terminal,
- the secondary winding of the current transformer has a first terminal and a second terminal corresponding to the respective terminals of the primary winding,
- the measurement value output of the DC measurement circuit is coupled to the second terminal of the secondary winding, and
- said combining circuit comprises a resistive connection between the first and second terminals of the secondary winding of the current transformer.

9. A driver device according to any of the preceding claims, wherein:
- said DC measurement circuit comprises a voltage integrator with an operational amplifier, the non-inverting input of which is coupled to said measured DC input and the inverting input of which is coupled to a reference potential, and the output of which constitutes said measurement value output.

10. A driver device according to any of claims 1 to 7, wherein:
- the AC measurement circuit comprises a current transformer with a primary winding and a secondary winding, of which the primary winding is a part of said current path,
- the secondary winding of said current transformer is coupled to a first input of a programmable integrated circuit,
- the measurement value output of the DC measurement circuit is coupled to a second input of said programmable integrated circuit, and
- said combining circuit consists of internal components of said programmable integrated circuit.

11. A method for measuring an electric current generated in a driver device for one or more semiconductor light sources, comprising:
- measuring an AC component of a periodically increasing and decreasing current controlled by said driver device, the magnitude of said periodically increasing and decreasing current being indicative of an output current through said semiconductor light sources, with a current transformer,
- measuring a DC component of said periodically increasing and decreasing current with a DC measurement circuit, and using an error amplifier to compare the measured DC component to a reference, so that the output of said error amplifier defines the measurement result of the DC component, and
- combining the signals from said current transformer and said DC measurement circuit into a superposition value indicative of the magnitude of said periodically increasing and decreasing current.

12. A method according to claim 11, comprising:
- comparing said superposition value to at least one reference value, and
- using the results of said comparing to time the switching of a power switch of a switched-mode power supply generating said output current.

13. A method according to claim 12, comprising:
- performing current hysteresis control of said power switch, so that said superposition value reaching or exceeding an upper limiting value triggers switching said power switch off, and said superposition value reaching or falling below a lower limiting value triggers switching said power switch on.
